Europäisches Patentamt

(19) European Patent Office

Office européen des brevets

(11) Veröffentlichungsnummer : **0 019 722**
**B1**

(12) **EUROPÄISCHE PATENTSCHRIFT**

(45) Veröffentlichungstag der Patentschrift :
09.06.82

(51) Int. Cl.³ : **H 01 L 29/78**, H 01 L 29/10

(21) Anmeldenummer : **80102240.1**

(22) Anmeldetag : 25.04.80

(54) **Integrierte Ladungsverschiebe-Mikroschaltung.**

(30) Priorität : 24.05.79 US 41975

(43) Veröffentlichungstag der Anmeldung :
10.12.80 (Patentblatt 80/25)

(45) Bekanntmachung des Hinweises auf die Patenterteilung : 09.06.82 Patentblatt 82/23

(84) Benannte Vertragsstaaten :
DE FR GB

(56) Entgegenhaltungen :
DE-A-2 240 790
IBM TECHNICAL DISCLOSURE BULLETIN, Band
20, Nr. 10, März 1978, New York, USA K.K. LIU :
« V-grooved chargecoupled device », Seite 3851.

IBM TECHNICAL DISCLOSURE BULLETIN, Band
21, Nr. 8, Januar 1979, New York, USA D.M.
KENNEY : « V-groove charge coupled device »,
Seite 3110.

IEEE TRANSACTIONS ON ELECTRON DEVICES,
Band ED-21, Nr. 12, Dezember 1974, New York,
USA W.J. BERTRAM et al. « A three-level metallization three-phase CCD », Seiten 758-767

SOLID STATE ELECTRONICS, Band 18, Nr. 12,
Dezember 1975, Oxford, GB C.M. PARKS et al.
« V-groove (VMOS) conductively connected
charge coupled devices », Seiten 1061-1067.

(73) Patentinhaber : International Business Machines Corporation
Armonk, N.Y. 10504 (US)

(72) Erfinder : Vanderslice, Wilbur Benjamin, Jr.
30 Oakcrest Drive
Burlington, Vermont 05401 (US)

(74) Vertreter : Busch, Robert, Dipl.-Ing.
Schönaicher Strasse 220
D-7030 Böblingen (DE)

Anmerkung : Innerhalb von neun Monaten nach der Bekanntmachung des Hinweises auf die Erteilung des
europäischen Patents im Europäischen Patentblatt kann jedermann beim Europäischen Patentamt gegen das erteilte
europäische Patent Einspruch einlegen. Der Einspruch ist schriftlich einzureichen und zu begründen. Er gilt erst als
eingelegt, wenn die Einspruchsgebühr entrichtet worden ist (Art. 99(1) Europäisches Patentübereinkommen).

Imprimerie Jouve, 18, rue St-Denis, 75001 Paris, France

## Integrierte Ladungsverschiebe-Mikroschaltung

Die Erfindung betrifft eine Anordnung, wie sie dem Oberbegriff des Anspruchs 1 zu entnehmen ist.

Ladungsgekoppelte Schieberegisteranordnungen gewinnen zunehmend an Bedeutung. Dementsprechend ist die Technik auf diesem Gebiet in fortdauernder Entwicklung begriffen. Die Kenntnis der Betriebseigenschaften und des Betriebsverhaltens auf diesem Gebiet hat bereits einen gewissen Abschluß gefunden und läßt sich mit Ausnahme von nur geringfügigen Änderungen dem Artikel « Charge-Coupled Devices — An Overview » von Walter F. Kosonocky, veröffentlicht in « 1974, Western Electronics Show and Convention Technical Papers », Band 18, 10. bis 13. September 1974, Seiten 2/2-2/20 entnehmen. Die wesentliche Struktur in der Ladungsverschiebe-Technik stellt ein Schieberegister dar, in welchem voneinander isolierte Ladungsträgerpakete, die Digital- oder Analogdaten entsprechen, an oder soeben unter der Oberfläche des Halbleiters verschoben werden. Die Möglichkeit zur Erfassung derartiger, verschobener Ladungsträgerpakete ist offensichtlich begrenzt durch deren wirksame Größe, was sich in den zum Betrieb derartiger ladungsgekoppelter Schieberegisteranordnungen erforderlichen Potentialen auswirkt und den jeweils erforderlichen, Oberflächenbereich festlegt, auf welchem diese Potentiale zur Einwirkung gelangen.

In den letzten Jahren ist danach gestrebt worden, die entsprechenden Treiberpotentiale bei Halbleiteranordnungen überhaupt herabzusetzen, um so die erforderliche Betriebsleistung zu verringern, so daß nun hinwiederum der Flächenbedarf bei diesen Anordnungen zu einem bedeutsamen Faktor wird. Mit einer speziell bei ladungsgekoppelten Anordnungen zu erwartenden Datenbit-Stellendichte in der Größenordnung von 250 000 und mehr Bits pro Halbleiterchip ist das leicht einzusehen.

Zur Erzielung entsprechend hoher Packungsdichten wird in der Zeitschrift « IEEE-Transactions on Electron Devices », Bd. ED-21, Nr. 12, Dezember 1974, Seiten 758 bis 767 eine integrierte Ladungsverschiebe-Mikroschaltung beschrieben, deren sich überlappende Streifenelektroden aus polykristallinem Silicium bestehen.

Andererseits sind in jüngster Vergangenheit integrierte Mikroschaltungen bekannt geworden, zu deren Herstellung Siliciumsubstrate einem anisotropen Ätzprozeß unterworfen worden sind, um so Halbleiterstrukturen zu erhalten, die mit nichtplanaren Oberflächen versehen sind. Eine generelle Beschreibung anisotropen Ätzens von Silicium läßt sich dem Artikel « Anisotropic Etching of Silicon » von Kenneth E. Bean, in « IEEE Transactions on Electron Devices », Bd. ED-25, Nr. 10, Oktober 1978, Seiten 1 185 bis 1 193 entnehmen. Grundsätzlich wird bei anisotropem Ätzen der Ätzangriff auf bestimmte kristallographische Ebenen eines kristallinen Substrats ausgeübt, so daß als Folge hiervon V-förmige Einkerbungen im betreffenden Oberflächenbereich entstehen. Wird so. z.B. ein Siliciumkristall zu derartigen Scheiben zerschnitten, daß deren Hauptoberflächen parallel zur (100)-Ebene liegen, dann führt anisotropes Ätzen V-förmige Einkerbungen in der Oberfläche der Halbleiterscheibe herbei, wobei die Seitenflanken der V-förmigen Einkerbungen in einem Winkel zur Hauptoberfläche liegen, der durch die Lage der (111)-Ebenen des Siliciumkristalls vorgegeben ist. Anisotropes Ätzen stellt also ein brauchbares Verfahren dar, um die vorgegebenen Abmessungen von Scheiben mit ladungsgekoppelten Schieberegisteranordnungen flächenmäßig besser auszunutzen.

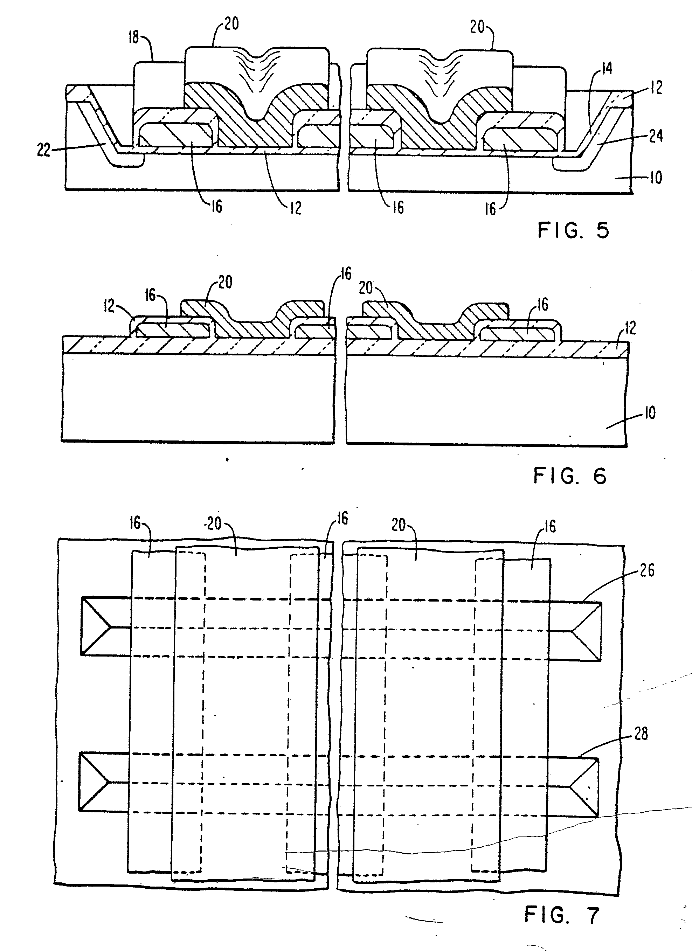

In der Veröffentlichung « V-Grooved Charge-Coupled Device » von K. K. Liu, im « IBM Technical Disclosure Bulletin », Bd. 20, Nr. 10, März 1978, Seite 3 851 wird eine ladungsgekoppelte Schieberegisteranordnung für Zweiphasen-Betrieb beschrieben, bei der die Speicherelektroden je teilweise innerhalb anisotropisch eingeätzter V-Einkerbungen in der Oberfläche eines Halbleitersubstrats liegen. Die Ladungsträgerpakete werden in einer derartigen Struktur durch das Einwirken von Verschiebeelektroden, die auf den Planaroberflächenbereichen des Substrats zwischen den V-förmigen Einkerbungen angeordnet sind, von einer V-förmigen Einkerbung auf die andere V-förmige Einkerbung verschoben. Eine derartige ladungsgekoppelte Schieberegisteranordnung entspricht im Aufbau einer ansonst bekannten ladungsgekoppelten Schieberegisteranordnung mit die Speicherelektroden überlappenden Verschiebeelektroden, wie es z.B. im Buch von D. Seitzer « Arbeitsspeicher für Digitalrechner » herausgegeben im Springerverlag auf der Seite 122 in der Abbildung 5.57. gezeigt ist. Eine andere. Art von ladungsgekoppelten Schieberegistern mit V-förmigen Einkerbungen einer Substratoberfläche ist dem Artikel « V-Groove Charge-Coupled Device » von D. M. Kenney, « IBM Technical Disclosure Bulletin » in Bd. 21, Nr. 8, Januar 1979, Seite 3 110 zu entnehmen, wo zur Herabsetzung des Oberflächenbedarfs für ein ladungsgekoppeltes Schieberegister die beiden Elektrodenarten jeweils auf den Einkerbungsflanken der anisotropisch geätzten Oberfläche angebracht sind.

An sich ist die Benutzung von anisotropisch angeätzten Halbleitersubstraten in der integrierten Mikroschaltungstechnik bekannt und weit verbreitet, um so höhere Dichten in der Bereitstellung von Bau- und/oder Schaltungselementen in Halbleiterscheibchen erzielen zu können. Ein Beispiel hierfür findet sich in dem Artikel « Capacitor for Single FET Memory Cell » von G. V. Clarke und J. E. Tomko in « IBM Technical Disclosure Bulletin », Bd. 17, Nr. 9, Februar 1975, Seiten 2 579 bis 2 580. In diesem Artikel wird die Verwendung von V-förmigen Einkerbungen als Teil eines MOS-Kondensators für ein einzelnes

FET-Speicherelement beschrieben, um den Flächenbedarf eines jeweiligen Speicherelements auf diese Weise herabzusetzen. Die US-Patentschrift 4 070 690 ist in diesem Zusammenhang ebenfalls interessant, wenn hier auch gegenüber den sonstigen Anordnungen U-förmige Einkerbungen in einem Vielschicht-Halbleitersubstrat Anwendung finden, um Vertikal-MOS-Transistoren bereitzustellen, wobei auch hier wiederum die Elektroden, parallel zu den Einkerbungen verlaufend, an deren Flanken angeordnet sind. Die deutsche Offenlegungsschrift 26 42 615 zeigt zwar Halbleitersubstrate mit V-förmigen Einkerbungen, jedoch sind hier in einer jeweiligen V-förmigen Einkerbung mehrere FET-Speicherelemente untergebracht, wobei zu deren Ansteuerung wahlweise adressierbare Wortleitungen, quer zu den V-förmigen Einkerbungen verlaufend, auf die Halbleiter-Substratoberflächen aufgebracht sind.

Schließlich ist aus dem Artikel « V-grooved charge-coupled device », erschienen in « IBM Technical Disclosure Bulletin » Bd. 20, Nr. 10, März 1978, Seite 3 851, ein Schieberegister gemäß dem 1. Teil des Anspruchs 1 bekannt.

Generell ist aber bei all diesen Anordnungen, die zur Herabsetzung des erforderlichen Oberflächenbedarfs mit V-förmigen Einkerbungen versehene Halbleitersubstrate verwenden, um die erzielbare Speicherdichte zu erhöhen, zu beachten, daß hierbei neben der Gefahr des Übersprechens Signalverluste zu verzeichnen sein können.

Das Ziel der Erfindung liegt somit darin, unter Erhöhen der Speicherdichte bei ladungsgekoppelten Schieberegisteranordnungen die Gefahr des Übersprechens und des Signalverlustes weitgehend auszuschalten.

Die Aufgabe der Erfindung läßt sich demnach darin sehen, daß ein Halbleitersubstrat mit mehreren V-förmigen Einkerbungen ausgenutzt wird, um eine betriebssichere, integrierte Ladungsverschiebe-Mikroschlatung bereitzustellen, die mit Hilfe üblicher Verfahren leicht herzustellen ist.

Erfindungsgemäß wird diese Aufgabe gelöst, wie es dem Kennzeichen des Anspruchs 1 zu entnehmen ist.

Aus der US-Patentschrift 4 126 881 ist es bekannt, eine Speicherzeile längs der Bitleitung mit einer V-förmigen Einkerbung zu versehen, deren Länge von der Anzahl hierin untergebrachter Speicherzellen abhängig ist.

Die der Erfindung zugrundeliegende, ladungsgekoppelte Schieberegisteranordnung befindet sich zusammen mit anderen Anordnungen dieser Art auf einem Halbleitersubstrat, in das eine größere Anzahl von parallel zueinander verlaufenden, anisotropisch eingeätzten Einkerbungen eingebracht sind, die gegenseitig voneinander elektrisch isoliert sind, indem Dickfilmoxid mit zwei verschiedenen Oxiddicken entsprechend auf die Substratoberfläche aufgebracht ist. In einem derartigen Oxiddickfilm liegen isoliert voneinander angeordnete, parallel zueinander verlaufende Streifenelektroden, die je nach ihrer Lage als Verschiebeelektroden oder Speicherelektroden dienen. Der Verlauf ist im wesentlichen senkrecht zur Einkerbungsrichtung ausgerichtet, so daß die Einkerbungen jeweils eine ladungsgekoppelte Schieberegisteranordnung darstellen. Beim Schieberegisterbetrieb werden hierbei Ladungsträgerpakete, wie an sich bekannt, unter Vermittlung von unterhalb der gänzlich innerhalb der Einkerbung liegenden Speicherelektroden unter der Wirkung der dazwischen liegenden Verschiebeelektroden von einer Speicherelektrode auf die andere verschoben. Da infolge des vollständigen Unterbringens von Speicher- und Verschiebeelektroden innerhalb der Einkerbungen die Einkerbungsflanken jeweils als Kanalzone für die Schieberegister dienen, läßt sich ohne nennenswerten Verlust des zu verschiebenden Signals der Flächenbedarf gegenüber sonstigen Anordnungen um 42 % herabsetzen. Zudem ist noch die Gefahr des Übersprechens von einer Schieberegisteranordnung auf die andere gegenüber bisher ganz wesentlich herabgesetzt.

Die Erfindung wird anschließend anhand einer Ausführungsbeispielsbeschreibung mit Hilfe der unten aufgeführten Zeichnungen näher erläutert.

Es zeigen :

Figur 1 bis Figur 4 Querschnittsausschnitte aus Halbleiternutzen zur Veranschaulichung der einzelnen Verfahrensschritte bei Herstellung einer intergrierten Ladungsverschiebe-Mikroschaltung gemäß der Erfindung,

Figur 5 einen Querschnittsausschnitt längs der Linie 5-5 in Fig. 4, aus welchem der Aufbau des jeweiligen Speicherelements der erfindungsgemäßen Anordnung hervorgeht,

Figur 6 einen Querschnittsausschnitt längs der Linie 6-6 der in Fig. 4 gezeigten Anordnung, aus der die Lage der Streifenelektroden bei Überqueren der Zwischenräume zwischen den Einkerbungen auf dem Oxiddickfilm hervorgeht,

Figur 7 eine schematische Draufsicht auf einen Ausschnitt der erfindungsgemäß aufgebauten, integrierten Ladungsverschiebe-Mikroschaltung.

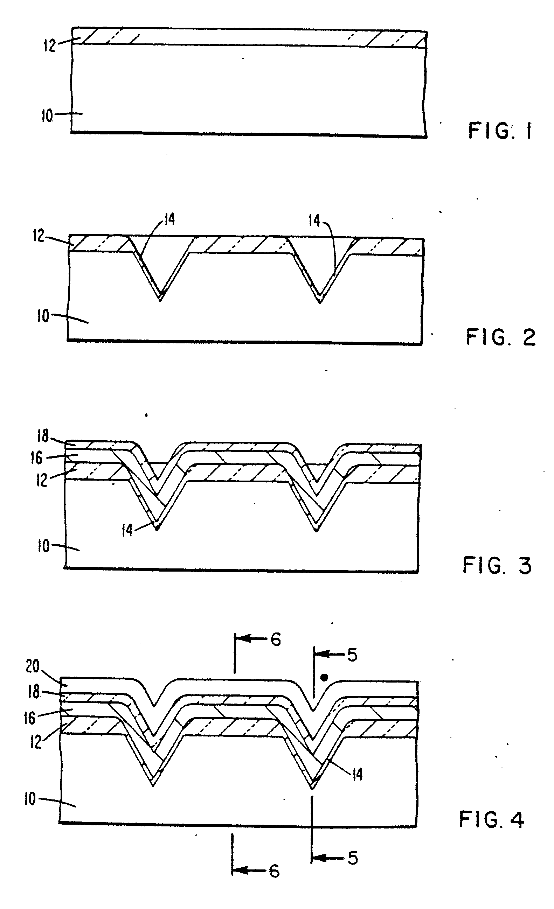

In Fig. 1 liegt ein monokristallines Halbleitersubstrat 10 vor, das z.B. P-leitend sein kann und einen spezifischen Widerstand von 2 bis 12 Ωcm aufweist. Für das Substrat 10 kann ebensogut auch eine auf einem anderen Halbleiter oder sonstigem geeigneten Material aufgebrachte Epitaxieschicht dienen.

Das Substrat 10 ist derart orientiert, daß die nach oben weisende Oberfläche parallel zur (100)-Ebene des Halbleiterkristalls ausgerichtet ist. Auf dieses Substrat 10 ist eine relativ dicke, dielektrische Schicht 12, bestehend z.B. aus einer 500 nm dicken, thermisch aufgewachsenen Siliciumdioxidschicht, aufgebracht, um eine parasitäre Ableitung zwischen den einzelnen, aktive Bauelemente aufweisenden Oberflächenbereichen, wie an sich bekannt, zu verhindern. Obgleich hier nur eine einzelne dielektrische Schicht 12 angedeutet ist, dürfte ohne weiteres einzusehen sein, daß auch andere Felddielektrikumstrukturen geeignet sein können, wie z.B. dielektrische Vielfachschichten, halb- oder vollabgelagertes Oxid, gebildet durch Anwenden einer die Oxidation verhindernden Siliciumnitridschicht, die anfänglich über Oberflächenbereiche mit aktiven Bauelementen aufgebracht ist, und durch verschiedene andere Kombinationen wohlbekannter Diffusions- und Ionenimplantations-Verfahrensschritte, die bisher zur Einstellung der Schwellenwertspannung unterhalb der Felddielektrikumsschicht 12 gedient haben.

Nach Aufbringen der Felddielektrikumsschicht 12 wird ein photolithographischer Ätzverfahrensschritt angewendet, um in vorgegebener Weise eine Anzahl von parallel zueinander verlaufenden, rechteckigen Gebieten der Halbleiteroberfläche freizulegen, in welche dann später die vorgesehenen ladungsgekoppelten Schieberegisteranordnungen eingebracht werden sollen. Die Abmessungen dieser rechteckförmigen Gebiete bestimmen sich durch die vorgesehene Größe der jeweiligen ladungsgekoppelten Schieberegisteranordnungen, wobei insbesondere die jeweilige ungefähre Länge der vorgesehenen Schieberegisteranordnungen maßgebend ist. Der seitliche Abstand zwischen benachbarten, rechteckigen Gebieten sollte so gewählt sein, daß sich eine angemessene Isolation zwischen den innerhalb der rechteckigen Gebiete einzubringenden ladungsgekoppelten Schieberegisteranordnungen ergibt, wobei beträchtliche Unterschiede in Abhängigkeit von der jeweils verwendeten Feldstruktur sowie von den elektrischen Parametern der durch die jeweiligen Prozesse gebildeten aktiven Bauelemente vorliegen können. Im Anschluß daran wird das Substrat anisotropisch geätzt, z.B. durch Anwenden von Äthylen-Diamin-Brenzkatechin und Wasser oder anderen an sich bekannten Lösungen für anisotropisches Ätzen, um die gewünschte Anzahl von sich longitudinal erstreckenden, V-förmigen Einkerbungen in den freigelegten Halbleiteroberflächenbereichen unter Eigenbegrenzung einzubringen. Eine ausführliche Beschreibung zum anisotropen Ätzen von Silicium findet sich im Artikel von K. E. Bean in « *IEEE Transactions on Electronic Devices* », Bd. ED-25, Nr. 10, Oktober 1978, Seiten 1 185 bis 1 192. Derart hergestellte V-förmige Einkerbungen weisen Seitenflanken und Endflächen auf, die in einem Winkel von 54,74°, wie durch die (111)-Ebene des kristallinen Substrats 10 festgelegt, ausgestattet sind. Nachdem Unterätzen an den kanten der Felddielektrikumsschicht 12 unerwünscht ist, ist es ratsam, das jeweilige halbleitersubstrat einer Tauchätzung zu unterziehen, um partiell eventuell überhängende Anteile der Felddielektrikumsschicht 12 zu entfernen, so daß die Seitenkanten der ausgeätzten Felddielektrikumsbereiche im wesentlichen geglättet und stetig in Fortsetzung der Flanken der V-förmigen Einkerbungen verlaufen.

Im Anschluß an das Ätzen der V-förmigen Einkerbungen wird innerhalb der V-förmigen Einkerbungen eine relativ dünne Schicht 14, bestehend z.B. aus thermisch aufgewachsenem Siliciumdioxid, auf die betreffenden Flanken aufgebracht, so daß sich die in Fig. 2 gezeigte Struktur ergibt. Diese Siliciumdioxidschicht 14 mag etwa 50 nm dick sein.

Hieran anschließend wird eine erste Schicht leitenden Materials über die gesamte Substratoberfläche, einschließlich der Oberflächenbereiche in den V-förmigen Einkerbungen aufgebracht. Diese etwa 300 nm dicke leitende Schicht wird vorzugsweise aus selbstpassivierendem, leitendem Material, wie z.B. dotiertem polykristallinem Silicium oder widerstandsfähigem Metall, gebildet.

Um aus dieser ersten leitenden Schicht eine Anzahl von parallel zueinander verlaufenden, jeweils in gleichem Abstand zueinander angeordneten, sich senkrecht zur Richtung der V-förmigen Einkerbungen erstreckenden, als Speicherelektroden dienenden Streifenelektroden 16 herzustellen, wird ein zweiter photolithographischer Verfahrensschritt angewendet. Nach Abschluß dieses Vorganges überqueren dann diese Streifenelektroden abwechselnd V-förmige Einkerbungen und dazwischenliegende Felddielektrikumsabschnitte. In diesem zuletzt genannten, photolithographischen Verfahrensschritt läßt sich die erste leitende Schicht gleichzeitig so mustern, daß Elektroden und Leitungsabschnitte für zusätzliche, hier nicht gezeigte, aktive und passive Bauelemente bereitgestellt werden können.

Nachdem so das durch die Streifenelektroden 16 gebildete erste Elektroden-Leiterbild aufgebracht ist, wird eine zweite dielektrische Schicht 18 zur Passivierung und Isolierung des ersten Elektroden-Leiterbildes niedergeschlagen. Die zweite dielektrische Schicht 18 besteht vorzugsweise aus thermisch aufgewachsenem Oxid, das durch Oxidation des ersten Elektroden-Leiterbildes bereitgestellt ist. Andererseits ließe sich hierzu auch ein chemischer Verdampfungsniederschlagsprozeß anwenden. Die zweite dielektrische Schicht 18 ist vorzugsweise etwa 150 nm dick. Die sich in diesem Verfahrensabschnitt ergebende Struktur ist in Fig. 3 dargestellt.

Nach Passivieren des ersten Elektroden-Leiterbildes wird eine zweite elektrisch leitende Schicht über das gesamte Substrat mit den Einkerbungen niedergeschlagen. Ein dritter photolithographischer Verfahrensschritt wird zur Bereitstellung eines zweiten Elektroden-Leiterbildes, bestehend aus parallel zueinander verlaufenden, jeweils in gleichem Abstand zueinander liegenden Streifenelektroden 20 aufgebracht, die als Verschiebeelektroden dienen sollen und hierzu jeweils teilweise die zuvor aufgebrachten Streifenelektroden 16 überlappen und zudem noch parallel hierzu verlaufen. Die geometrische und elektrische Zuordnung der Streifenelektroden 16 zu den Streifenelektroden 20 ist an sich aus der einschlägigen Technik bekannt ; es sei hierzu nur auf die bereits erwähnte Veröffentlichung mit dem Artikel « Charge-Coupled Devices — An overview »

von W. F. Kosonocky in « 1974 Western Electronics Show and Convention Technical Papers », Bd. 18, 10. bis 13. September, Seiten 2/1-2/20 verwiesen.

Nach Bilden des zweiten Elektroden-Leiterbildes läßt sich die sich ergebende integrierte Ladungsverschiebe-Mikroschaltung je nach dem vorgesehenen Anwendungszweck weiter behandeln.

Fig. 5 zeigt einen Querschnitt, der durch die Tallinie einer fertiggestellten integrierten Ladungsverschiebe-Mikroschaltung gelegt ist. Die hier gezeigten N-Zonen 22 und 24 bilden PN-Übergänge zum Substrat 10 und stellen Ein- und Ausgänge der ladungsgekoppelten Schieberegisteranordnungen dar. Diese N-Halbleiterzonen 22 und 24 lassen sich mit Hilfe bekannter Verfahren, wie Diffusion oder Ionenimplantation, an den vorgesehenen Stellen anbringen. Es sei darauf hingewiesen, daß die Abschnittsausschnitte der Streifenelektroden 16 und 20 innerhalb der Einkerbungen, wie in Fig. 5 gezeigt, eine ähnliche Form haben, wie es bei bisher üblichen ladungsgekoppelten Schieberegisteranordnungen mit zwei verschiedenen Oxiddicken in Silicium-Gate-Technik bekannt ist. Das bedeutet, daß insoweit auch gleiche Charakteristiken vorliegen. Obgleich nicht speziell dargestellt, ist der Gesamtquerschnitt, d.h. der längs der Seitenflanken der V-förmigen Einkerbung sowie der in der Tallinie der V-förmigen Einkerbung, identisch mit dem in Fig. 5 gezeigten. Daraus erhellt, daß der durch die ladungsgekoppelte Schieberegisteranordnung beanspruchte Oberflächenbereich, wie er sich aus der Ebene der Halbleiter- oder Substrathauptfläche ergibt, dank der Erfindung 1,73 mal größer ist, als es bei dem auf einem planaren Halbleitersubstrat beanspruchten Flächenbereich einer ladungsgekoppelten Schieberegisteranordnung der Fall wäre.

Fig. 6 zeigt einen schematischen Querschnitt, bei dem die Streifenelektroden 16 und 20 über dem Felddielektrikum 12 verlaufen, indem sie so von der Substratoberfläche isoliert sind. In diesem Falle ist jedoch die Dicke des Felddielektrikums 12 größer, als es bei der Tallinie in der V-förmigen Einkerbung der Fall ist.

Fig. 7 läßt die Oberflächengestaltung der erfindungsgemäßen integrierten Ladungsverschiebe-Mikroschaltung erkennen. Insbesondere ist hierzu sehen, daß die zueinander parallel liegenden V-förmigen Einkerbungen 26 und 28 sowohl von den als Verschiebeelektroden dienenden Streifenelektroden 20 als auch von den als Speicherelektroden dienenden Streifenelektroden 16 in orthogonaler Richtung überquert werden.

Abweichend von den gezeigten Ausführungen der Streifenelektroden 16 und 20 lassen sich auch andere Strukturen nach Bedarf bereitstellen. Ganz am Rande versteht es sich, daß verschiedene Betriebsmöglichkeiten außer dem bereits erwähnten Zweiphasenbetrieb Anwendung finden können, wie Dreiphasen- oder allgemein Mehrphasenbetrieb. Das beschriebene Ausführungsbeispiel der Erfindung stützt sich zwar auf anisotrop geätztes Silicium, jedoch können ebensogut auch andere Verfahrensweisen bei sonstigen Halbleitern Anwendung finden, um Einkerbungen in den betreffenden Halbleitersubstraten zur Erhöhung der für die aktiven Bauelemente erforderlichen Oberflächenbereiche vorzusehen. So könnten z.B. durch Anwenden eines partialen, anisotropen Ätzvorgangs für V-förmige Einkerbungen U-förmige Einkerbungen oder solche mit flachem Boden hergestellt werden. Andere Naß- oder Trockenätzverfahren, wie z.B. reaktives Ionenätzen, lassen sich ebenfalls als geeignete Methoden ansehen, um, wie erwünscht, Einkerbungen in eine Halbleiteroberfläche einzubringen. Es ist allerdings nicht von der Hand zu weisen, daß die Bereitstellung V-förmiger Einkerbungen mittels anisotropischer Ätzverfahren zur Herstellung der erfindungsgemäßen, integrierten Ladungsverschiebe-Mikroschaltung bevorzugt wird, wo im Hinblick auf das relativ leichte Anbringen von Streifenelektroden, die sich hierbei gleichförmig den Einkerbungsflanken anschmiegen ein großer Vorteil liegt ; wobei im wesentlichen dann auch eine gleichförmige und gleichbleibende Dicke zu erhalten ist.

Das Aufbringen der Elektroden-Leiterbilder kann ebensogut auch durch Vakuum- oder Ionisationsverfahrenstechniken erfolgen, was insbesondere dann von Vorteil sein könnte, wenn die Einkerbungsflanken anstatt wie gezeigt, steilere Winkel aufweisen, so daß in diesem Falle noch für eine zuverlässige Betriebsweise erforderliche Elektrodencharakteristiken zu erzielen sind.

**Ansprüche**

1. Integrierte Ladungsverschiebe-Mikroschaltung mit zumindest einer zur Bereitstellung von hierin enthaltenen Bau- und/oder Schaltungselementen im Oberflächenbereich eines Halbleiters angebrachten Einkerbung (26, 28), deren Oberfläche zusammen mit dem übrigen Oberflächenbereich von einer dielektrischen Isolierschicht (12, 14) bedeckt ist, die ihrerseits zwei voneinander isoliert angebrachte, sich teilweise überlappende Elektroden-leiterbilder (16, 20) trägt, derart, daß zumindest eines hiervon unter Überlappen der Einkerbungsränder die den einzelnen Speicherelementen zugeordnete Einkerbungs-oberflächenbereiche überzieht, und mit jeweils am Ein- und Ausgang der Schieberegister angeordneten, mit dem Halbleiter einen PN-Übergang bildenden, als Source und Drain wirkenden Halbleiterzonen (22, 24), dadurch gekennzeichnet, daß die jeweilige Einkerbung (26, 28) eine von der Anzahl der hierin untergebrachten Speicherelemente abhängige Länge und an entgegengesetzten Enden die als Source und Drain wirkenden Halbleiterzonen (22, 24) aufweist und daß die Elektroden-Leiterbildet in Form paralleler Leitungszüge (16, 20) quer zur Einkerbungsrichtung liegen.

2. Anordnung nach Anspruch 1, dadurch gekennzeichnet, daß die jeweilige Einkerbung (26, 28) V-förmigen Querschnitt hat.

3. Anordnung nach Anspruch 1 und Anspruch 2, dadurch gekennzeichnet, daß der Halbleiter aus einem monokristallinen, parallel zur (100)-Ebene orientierten Substrat (10) aus Silicium besteht, worin die Einkerbungsoberflächen zumindest teilweise durch (111)-Flächen des Siliciumkristalls definiert sind.

4. Anordnung nach den Ansprüchen 1 bis 3, dadurch gekennzeichnet, daß die Speicherelektroden darstellenden, teilweise vom zweiten Elektroden-Leiterbild überlappten Streifenelektroden (16) des ersten Elektroden-Leiterbildes aus einem selbstpassivierenden, leitenden Material bestehen.

5. Anordnung nach Anspruch 4, dadurch gekennzeichnet, daß das Elektrodenmaterial aus polykristallinem Silicium besteht.

**Claims**

1. Integrated charge transfer microcircuit with at least one recess (26, 28) notched in the surface of a semi-conductor to contain components and/or circuit elements housed therein, the surface of said recess together with the remainder of the surface being covered by a dielectric insulation layer (12, 14) which itself carries two partially overlapping conductive electrode patterns (16, 20) insulated from each other, in such a manner that at least one of these patterns covers, by overlapping the recess edges, the recess surface areas associated to the individual storage elements, and with semiconductor regions (22, 24) arranged at each input and each output of the shift registers, said semiconductor regions forming a PN-junction with the semiconductor and acting as source and drain, characterized in that each recess (26, 28) is of a length depending on the number of storage elements housed therein, and that it has the semiconductor regions (22, 24) acting as source and drain at opposite ends, and that the conductive electrode patterns are arranged in the form of parallel conductive lines (16, 20) transversally to the recess direction.

2. Arrangement as claimed in claim 1, characterized in that each recess (26, 28) has a V-shaped cross-section.

3. Arrangement as claimed in claim 1 and claim 2, characterized in that the semiconductor consists of a monocrystalline substrate (10) of silicon oriented in parallel to the (100) plane, the recess surfaces being defined at least partially by (111) planes of the silicon crystal.

4. Arrangement as claimed in claims 1 to 3, characterized in that the longitudinal electrodes (16) of the first conductive electrode pattern which represent storage electrodes and which are partially overlapped by the second conductive electrode pattern consist of a self-passivating conductive material.

5. Arrangement as claimed in claim 4, characterized in that the electrode material consists of polycrystalline silicon.

**Revendications**

1. Circuit micro-électronique intégré à transfert de charges comportant : au moins un évidement (26, 28) pratiqué à la surface d'un semiconducteur pour rendre accessible les composants et/ou des éléments de circuit qui y sont contenus, la surface de cet évidement et le reste de ladite surface sont recouverts par une couche isolante diélectrique (12, 14), cette dernière porte deux configurations d'électrodes (16, 20), isolées l'une de l'autre et se chevauchant partiellement de telle sorte qu'au moins l'une d'elles recouvre, les bords de l'évidement par chevauchement et les surfaces d'évidement associées avec les différents éléments de mémoire, et des régions semiconductrices (22, 24) constituant la source et le drain disposés à l'entrée et à la sortie des registres à décalage et formant avec le semi-conducteur une jonction PN, ce circuit étant caractérisé en ce que chaque évidement (26, 28) a une longueur qui dépend du nombre des éléments de mémoire qui y sont contenus et comporte, aux extrémités opposées, les régions semi-conductrices (22, 24) servant de source et de drain, et en ce que lesdites configurations d'électrodes forment des conducteurs parallèles (16, 20) disposés transversalement par rapport à la direction de l'évidement.

2. Arrangement selon la revendication 1, caractérisé en ce que chaque évidement (26, 28) a une coupe en forme de V.

3. Arrangement selon les revendications 1 et 2, caractérisé en ce que le semi-conducteur est composé d'un substrat (10) de silicium monocristallin d'orientation cristalline parallèle au plan (100), les surfaces d'évidement étant définies, au moins partiellement, par les plans (111) du cristal de silicium.

4. Arrangement selon les revendications 1 à 3, caractérisé en ce que les électrodes longitudinales (16) de la première configuration d'électrode, constituant les électrodes de mémoire, sont partiellement chevauchées par la seconde configuration d'électrode, et sont composées d'un matériau conducteur auto-passivant.

5. Arrangement selon la revendication 4, caractérisé en ce que le matériau constitutif des électrodes est en silicium polycristallin.

FIG. 1

FIG. 2

FIG. 3

FIG. 4

FIG. 5

FIG. 6

FIG. 7